Europäisches Patentamt

(19) European Patent Office

Office européen des brevets

(11) EP 0 967 658 A2

(12) EUROPEAN PATENT APPLICATION

(43) Date of publication:
29.12.1999 Bulletin 1999/52

(51) Int. Cl.⁶: $H01L\ 29/66$, $H01L\ 29/15$

(21) Application number: 99108056.5

(22) Date of filing: 23.04.1999

(84) Designated Contracting States:
AT BE CH CY DE DK ES FI FR GB GR IE IT LI LU MC NL PT SE
Designated Extension States:
AL LT LV MK RO SI

(30) Priority: 24.04.1998 JP 13145598

(71) Applicant:
Canare Electric Co., Ltd.
Aichi-gun, Aichi-ken 480-1101 (JP)

(72) Inventor: Kano, Hiroyuki
Nishikamo-gun, Aichi-ken 470-0201 (JP)

(74) Representative:
Pellmann, Hans-Bernd, Dipl.-Ing. et al
Patentanwaltsbüro
Tiedtke-Bühling-Kinne & Partner
Bavariaring 4
80336 München (DE)

(54) Semiconductor device with quantum-wave interference layers

(57) A semiconductor device of an nin, or pip type, constituted by a quantum-wave interference layer with plural periods of a pair of a first layer W and a second layer B. The second layer B has wider band gap than the first layer W. Each thicknesses of the first layer W and the second layer B is determined by multiplying by an even number one fourth of wavelength of quantum-wave of carriers in each of the first layer W and the second layer B existing at the level near the lowest energy level of the second layer B. A δ layer, for sharply varying energy band, is formed at an every interface between the first layer W and the second layer B and has a thickness substantially thinner than the first layer W and the second layer B. Then carriers can have a high conductivity, a high mobility, or a high transmittivity, and a propagation velocity is improved.

F I G. 9

EP 0 967 658 A2

**Description**

BACKGROUND OF THE INVENTION

Field of the invention

The present invention relates to a quantum-wave interference layer which transmits carriers, i.e., electrons or holes effectively. Especially, the present invention relates to a semiconductor device with a new structure, which improves a mobility and a transmission velocity.

Description of the Related Art

A semiconductor device has been known to have a double hetero junction structure whose active layer is formed between n-type and p-type cladding layers. The cladding layers function as potential barriers for effectively confining carriers, or electrons and holes, within the active layer.
However, a problem persists in luminous efficiency. Carriers overflow the potential barriers of the cladding layers, which lowers luminous efficiency. Therefore, further improvement has been required, as presently appreciated by the present inventors.
As a countermeasure, forming cladding layers with a multi-quantum well structure of a first and a second layer as a unit has been suggested by Takagi et al. (Japanese Journal of Applied Physics. Vol. 29, No.11, November 1990, pp.L1977-L1980). This reference, however, does not teach or suggest values of kinetic energy of carriers to be considered and the degree of luminous intensity improvement is inadequate.

SUMMARY OF THE INVENTION

The inventors of the present invention conducted a series of experiments and found that the suggested thicknesses of the first and the second layers by Takagi et al. were too small to confine electrons, and that preferable thicknesses of the first and second layers are 4 to 6 times larger than those suggested by Takagi et al. Further, the present inventors thought that multiple quantum-wave reflection of carriers might occur by a multi-layer structure with different band width, like multiple light reflection by a dielectric multi-film structure. And the inventors thought that it would be possible to confine carriers by the reflection of the quantum-wave interference layer and applications of the same.
Then the inventors of the present invention concerned a characteristic of electrons as a wave and considered that the quantum-wave interference layer functions as a transmission layer of carriers, by analogy with the multiple reflection of the light. That is, when each thickness of layers in the multi-layer structure is about an order of the wavelength of a quantum-wave of carriers, an interference effect of quantum-wave is considered to be occurred with respect to a conduction of carriers in the multi-layer structure. The interference effect caused a conduction as a wave. Accordingly, the inventors of the present invention considered that not a conduction of particle in a classical theory but a resonance of waves, an interference, or other phenomenon is occurred by an interference effect of electrons. This wave behavioral characteristic of electrons improves a mobility and a propagation velocity. Consequently, the semiconductor device of the present invention can be applied to various semiconductor devices.
It is, therefore, a first object of the present invention to provide a quantum-wave interference layer, with a high transmittivity and a high mobility to carriers, functioning as a transmission layer. It is a second object of the present invention to improve quantum-wave transmittivity by additionally providing a new layer structure with a multi-layer structure whose band width is different with respect to each other. It is a third object of the invention to provide variations of a quantum-wave interference layer for effectively transmitting quantum-waves.
In light of these objects a first aspect of the present invention is a semiconductor device constituted by a quantum-wave interference layer having plural periods of a pair of a first layer and a second layer, the second layer having a wider band gap than the first layer. Each thickness of the first and the second layers is determined by multiplying by an even number one fourth of a quantum-wave wavelength of carriers in each of the first and the second layers.
The second aspect of the present invention is to form each thickness of the first and the second layers by multiplying by an even number one fourth of quantum-wave wavelength of carriers in each of the first and the second layers existing at the level near the lowest energy level of the second layer.
The third aspect of the present invention is to form a δ layer, which varies an energy band sharply, at an interval between the first and the second layers. A thickness of the δ layer is substantially thinner than that of the first and the second layers.
The fourth aspect of the present invention is to define each thickness of the first and the second layers as follows:

$$D_w = n_W \lambda_W / 4 = n_W h / 4 [2m_W (E+V)]^{\frac{1}{2}} \qquad (1)$$

and

$$D_B = n_B \lambda_B / 4 = n_B h / 4 (2m_B E)^{\frac{1}{2}} \qquad (2)$$

In Eqs. 1 and 2, h, $m_W$, $m_B$, E, V, and $n_W$, $n_B$ represent Plank's constant, the effective mass of carrier in the first layer, effective mass of carriers in the second layer, the kinetic energy of the carriers at the level near the lowest energy level of the second layer, the potential energy of the second layer relative to the first layer, and even numbers, respectively.

The fifth aspect of the present invention is a semiconductor device having a plurality of partial quantum-wave interference layers $I_k$ with arbitrary periods $T_k$ including a first layer having a thickness of $D_{Wk}$ and a second layer having a thickness of $D_{Bk}$ and arranged in series. The thicknesses of the first and the sdcond layers satisfy the formulas:

$$D_{Wk} = n_{Wk} \lambda_{Wk} / 4 = n_{Wk} h / 4 [2m_{Wk} (Ek+V)]^{\frac{1}{2}} \qquad (3)$$

and

$$D_{Bk} = n_{Bk} \lambda_{Bk} / 4 = n_{Bk} h / 4 (2m_{Bk} E_k)^{\frac{1}{2}} \qquad (4)$$

In Eqs. 3 and 4, $E_k$, $m_{Wk}$, $m_{Bk}$, and $n_{Wk}$, $n_{Bk}$ represent plural kinetic energy levels of carriers flowing into the second layer, effective mass of carriers with kinetic energy $E_k+V$ in the first layer, effective mass of carriers with kinetic energy $E_k$ in the second layer, and arbitrary even numbers, respectively.

The plurality of the partial quantum-wave interference layers $I_k$ are arranged in series from $I_1$ to $I_j$, where j is a maximum number of k required to from a quantum-wave interference layer as a whole.

The sixth aspect of the present invention is a semiconductor device having a quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial parts are represented by $(D_{W1}, D_{B1})$, ..., $(D_{Wk}, D_{Bk})$, ..., $(D_{Wj}, D_{Bj})$. $(D_{Wk}, D_{Bk})$ is a pair of widths of the first and second layers and is defined as Eqs 3 and 4, respectively.

The seventh aspect of the present invention is a semiconductor device having a quantum-wave interference layer constituted by a plurality of semiconductor layers made of a hetero-material with different band gaps. The interference layer is constituted by a plurality of δ layers for sharply varying the energy band and being formed at an interval of one fourth of a quantum-wave wavelength of carriers multiplied by an even number. The thickness of the δ layers is significantly thinner than the width of the interval.

When a single level E of kinetic energy is adopted, the interval $D_B$ between the δ layers is calculated by Eq. 2. When plural levels $E_k$ of kinetic energy are adopted, the interval $D_{Bk}$ between the δ layers are calculated by Eq. 4. In the latter case, several partial quantum-wave interference layers $I_k$ with the δ layers formed at an interval $D_{Bk}$ in $T_k$ periods may be arranged in series from $I_1$ to $I_j$ to form a quantum-wave interference layer as a whole. Alternatively, the partial quantum-wave interference layer may be formed by serial S layers with intervals of $D_{B1}$, ..., $D_{Bk}$, ..., to $D_{Bj}$, and the plurality of the partial quantum-wave interference layers may be arranged in series with an arbitrary period.

The eighth aspect of the present invention is to use the quantum-wave interference layer as a transmission layer for transmitting carriers.

The ninth aspect of the present invention is to constitute a quantum-wave incident facet in the quantum-wave interference layer by a second layer with enough thickness for preventing conduction of carriers by a tunneling effect.

The tenth aspect of the present invention is a semiconductor device constituted by an nin or pip structure, and wherein a quantum-wave interference layer described in one of the first to ninth aspects of the present invention is formed in the i-layer.

The eleventh aspect of the present invention is to form the second layer in the i-layer having the same band width as that of the n-layer or p-layer.

The twelfth aspect of the present invention is a semiconductor device constituted by an nin structure, and wherein the lowest level of a conduction band of the second layer formed in the i-layer is corresponded to that of the second layer in the n-layer.

The thirteenth aspect of the present invention is a semiconductor device constituted by a pip structure, and wherein the lowest level of a valence band of the second layer formed in the i-layer is corresponded to that of the second layer in the p-layer.

First, second, and fourth aspects of the invention

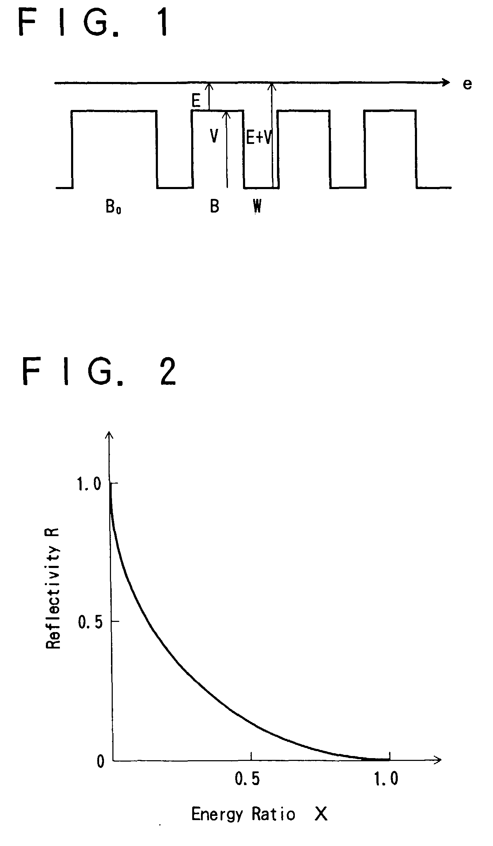

The principle of the quantum-wave interference layer of the present invention is explained hereinafter. FIG. 1 shows a conduction band of a multi-layer structure with plural periods of a first layer W and a second layer B as a unit. A band gap of the second layer B is wider than that of the first layer W. Electrons conduct from left to right as shown by an arrow in FIG. 1. Among the electrons, those that exist at the level near the lowest energy level of a conduction band in the second layer B are most likely to contribute to conduction. The electrons near the bottom of conduction band of the second layer B has a kinetic energy E. Accordingly, the electrons in the first layer W have a kinetic energy E+V which is accelerated by potential energy V due to the band gap between the first layer W and the second layer B. In other words, electrons that move from the first layer W to the second layer B are decelerated by potential energy V and return to the original kinetic energy E in the second layer B. As explained above, kinetic energy of electrons in the conduction band is modulated by potential energy due to the multi-layer structure.

When thicknesses of the first layer W and the second layer B are equal to order of quantum-wave wavelength, electrons tend to have characteristics of a wave. The wave length of the electron quantum-wave is calculated by Eqs. 1 and 2 using kinetic energy of the electron. Further, defining the respective wave number vector of first layer W and second layer B as $K_W$ and $K_B$, reflectivity R of the wave is calculated by:

$$R = (|K_W|-|K_B|) / (|K_W|+|K_B|) \tag{5}$$
$$= ([m_W(E+V)]^{1/2}-[m_B E]^{1/2}) / ([m_W(E+V)]^{1/2}+[m_B E]^{1/2})$$
$$= [1-(m_B E/m_W(E+V))^{1/2}] / [1+(m_B E/m_W(E+V))^{1/2}]$$

Further, when $m_B = m_W$, the reflectivity R is calculated by:

$$R = [1-(E/(E+V))^{1/2}]/[1+(E/(E+V))^{1/2}] \tag{6}$$

When $E/(E+V) = x$, Eq. 6 is transformed into:

$$R = (1-x^{1/2}) / (1+x^{1/2}) \tag{7}$$

The characteristic of the reflectivity R with respect to the energy ratio x obtained by Eq. 7 is shown in Figure 2.

When the condition $x \leq 1/10$ is satisfied, $R \geq 0.52$. Accordingly, the relation between E and V is satisfied with:

$$E \leq V/9 \tag{8}$$

Since the kinetic energy E of the conducting electrons in the second layer B exists near the bottom of the conduction band, the relation of Eq. 9 is satisfied and the reflectivity R at the interface between the second layer B and the first layer W becomes 52 % or more. Consequently, the multi-layer structure having two kinds of layers with band gaps different from each other enables to reflect quantum-wave of electrons, which conduct in an i-layer, between the first and second layers.

Further, utilizing the energy ratio x enables the thickness ratio $D_B/D_W$ of the second layer B to the first layer W to be obtained by:

$$D_B/D_W = [m_W / (m_B x)]^{1/2} \tag{9}$$

When thicknesses of the first and second layers are determined by multiplying an even number by one fourth of a quantum-wave wavelength, or by a half of a quantum-wave wavelength, for example, a standing wave rises in a quantum-wave interference layer, and a resonant conduction is occurred. That is, when a quantum-wave period of the standing wave and a potential period of the quantum-wave interference layer is corresponded to each other, a scattering of the carrier in each layer is suppressed, and a conduction of a high mobility is realized.

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for transmitting electrons is not optimum for transmitting holes. Eqs. 5-9 refer to a structure of the quantum-wave interference layer for transmitting electrons selectively. The thickness for selectively transmitting electrons is designed based on a difference in potential energy of the conduction band and effective mass of electrons. Consequently, the quantum-wave interference layer has a high transmittivity (or a high mobility) for electrons, but not for holes.

Further, the thickness for selectively transmitting holes is designed based on a difference in potential energy of the valence band and effective mass of holes, realizing another type of quantum-wave interference layer as a hole transmission layer, which has a high mobility for holes and which has an ordinary mobility for electrons.

## Fifth aspect of the present invention

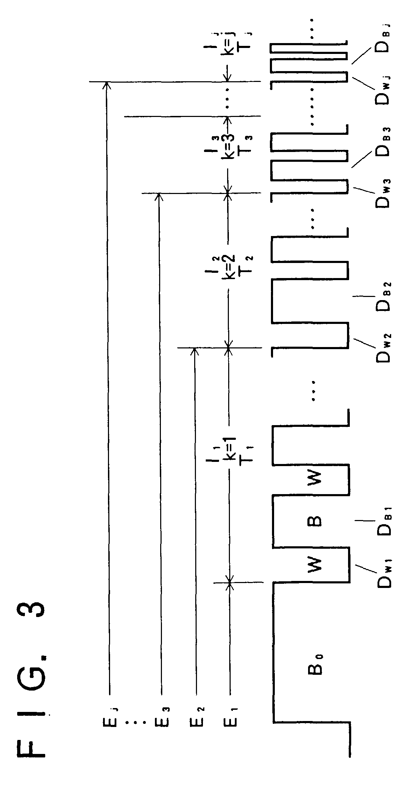

As shown in FIG. 3, a plurality of partial quantum-wave interference layers $I_k$ may be formed corresponding to each of a plurality of kinetic energy levels $E_k$. Each of the partial quantum-wave interference layers $I_k$ has $T_k$ periods of a first layer W and a second layer B as a unit whose respective thicknesses ($D_{Wk}$, $D_{Bk}$) are determined by Eqs. 3 and 4. The plurality of the partial quantum-wave interference layer $I_k$ is arranged in series with respect to the number k of kinetic energy levels $E_k$. That is, the quantum-wave interference layer is formed by a serial connection of $I_1$, $I_2$, ..., and $I_j$. As shown in FIG. 3, electrons with each of the kinetic energy levels $E_k$ are transmitted by the corresponding partial quantum-wave interference layers $I_k$. Accordingly, electrons belonging to each of the kinetic energy levels from $E_1$ to $E_j$ are transmitted effectively. By designing the intervals between the kinetic energies to be short, thicknesses of the first layer W and the second layer B ($D_{Wk}$, $D_{Bk}$) in each of the partial quantum-wave interference layers $I_k$ vary continuously with respect to the value k.

## Sixth aspect of the present invention

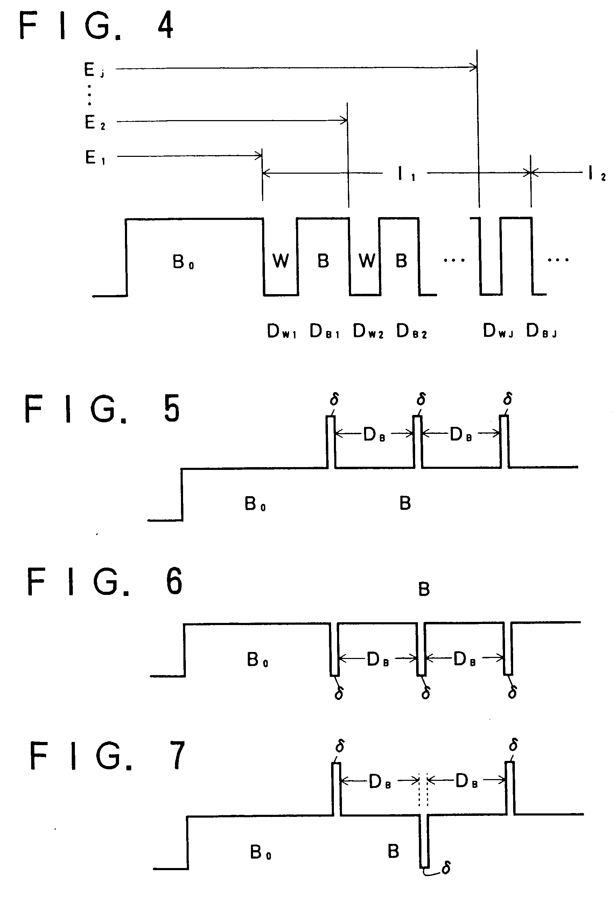

As shown in FIG. 4, a plurality of partial quantum-wave interference layers may be formed with an arbitrary period. Each of the partial quantum-wave interference layers $I_1$, $I_2$, ... is made of serial pairs of the first layer W and the second lyaer B with widths ($D_{Wk}$, $D_{Bk}$) determined by Eqs 3 and 4. That is, the partial quantum-wave interference layer, e.g., $I_1$, is constructed with serial layers of width ($D_{W1}$, $D_{B1}$), ($D_{W2}$, $D_{B2}$), ..., ($D_{Wj}$, $D_{Bj}$), as shown. A plurality $I_1$, $I_2$, ... of layers such as layer $I_1$ are connected in series to form the total quantum-wave interference layer. Accordingly, electrons of the plurality of kinetic energy levels $E_k$ are reflected by each pair of layers in each partial quantum-wave interference layers. By designing the intervals between kinetic energies to be short, thicknesses of the pair of the first layer W and the second layer B ($D_{Wk}$, $D_{Bk}$) in a certain partial quantum-wave interference layer varies continuously with respect to the value k.

## Third aspect of the present invention

The third aspect of the present invention are directed to forming a δ layer at the interface between the first layer W and the second layer B. The δ layer has a relatively thinner thickness than both of the first layer W and the second layer B and sharply varies an energy band. Reflectivity R of the interface is determined by Eq. 7. By forming the δ layer, the potential energy V of an energy band becomes larger and the value x of Eq. 7 becoues smaller. Accordingly, the reflectivity R becomes larger.

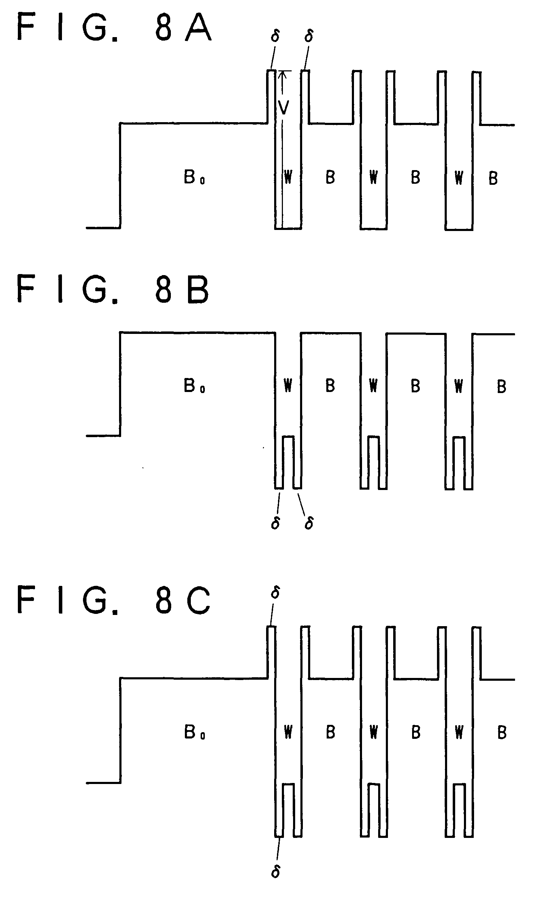

Variations are shown in FIGS. 8A to 8C. The δ layer may be formed on both ends of the every first layer W as shown in FIGS. 8A to 8C. In FIG. 8A, the δ layers are formed so that an energy level higher than that of the second layer B may be formed. In FIG. 8B, the δ layers are formed so that an energy level higher than that of the second layer B may be formed. In FIG. 8B, the δ layers are formed so that an energy level lower than that of the first layer W may be formed. In FIG. 8C, the δ layers are formed so that the energy level higher than that of the second layer B and the energy level lower than that of the first layer W may be formed. As an alternative to each of the variations shown in FIGS. 8A to 8C, the δ layer can be formed on one end of the every first layer W.

Forming one δ layer realizes large quantum-wave reflectivity at the interface between the first layer W and the second layer B and a plurality of the δ layers realizes a larger reflectivity as a whole.

Thus when the reflectivity between the first and second layer is improved by the δ layer, a standing wave of carrier quantum-wave in the quantum-wave interference layer becomes larger. Accordingly, a high conductivity (or a high transmittivity) of carriers is achieved. And the δ layer improves a sharpness of band structure of boundary between the first and the second layers which improves periodity of a standing wave to increase transmittivity of carriers.

## Seventh aspect of the present invention

The seventh aspect of the present invention is to form a plurality of δ layers in second layer B at an interval $D_B$ determined by Eq. 2. Variations are shown in FIGS. 5 to 7. In FIG. 5, the δ layer is formed so that an energy level higher than that of the second layer B may be formed. In FIG. 6, the δ layer is formed so that an energy level lower than that of the second layer B may be formed. In FIG. 7, the δ layer is formed alternately so that the higher and lower energy levels than the second layer B may be formed.

When a plurality of energy levels of electrons are set, the interval $D_B$ between the $\delta$ layers in the second layer B corresponds to thicknesses $D_{Bk}$ of the second layer B in FIGS. 3 and 4. Accordingly, a quantum-wave interference layer can be made from a serial connection of a number j of partial quantum-wave interference layers $I_k$ as shown in FIG. 3. In this case, $\delta$ layers are disposed at an interval $D_{Bk}$ with period $T_k$ in each partial interference layers and the number j corresponds to the kinetic energy of electrons. Alternatively, the $\delta$ layers may be arranged at an interval from $D_{B1}$ to $D_{Bj}$ in series and may be formed in the second layer B so as to make the partial quantum-wave interference layers and the plurality of the partial quantum-wave interference layers, arranged in series as shown in FIG. 4. In this structure, a standing wave of carrier quantum-wave in the quantum-wave interference layer also becomes larger.

Eighth aspect of the present invention

The eighth aspect of the present invention is directed to a quantum-wave interference layer that functions as a conduction layer and selectively transmits carriers in an adjacent layer. As mentioned above, the quantum-wave interference layer can be designed to transmit with a high conductivity either electrons or holes selectively. Considering this as a transmission of quantum waves, a high conduction of carriers can be possible.

Ninth aspect of the present invention

The ninth aspect of the present invention, or forming a thick second layer $B_0$ at the side of an incident plane of the quantum-wave interference layer, and effectively prevents conduction by tunneling effects and reflects carriers.

Tenth, eleventh, and twelfth aspects of the present invention

The tenth, eleventh, and twelfth aspects of the present invention is directed to form the quantum-wave interference layers described above in a i-layer with a pip or an nin structure to obtain a high conductivity and a high mobility of carriers placed between both sides of the p-layer or the n-layer. And when the band width of the second layer in the quantum-wave interference layer corresponds to that of the n-layer or the p-layer, a high conductivity or a high mobility of carriers can be obtained. Similarly, when a conduction band of the n-layer is formed at the same level of that of the second layer B, a high conductivity or a high mobility of electrons can be obtained. Further, by forming valence bands of the p-layer and the second layer B to have the same level, a high conductivity and a high mobility of holes can be obtained.

BRIEF DESCRIPTION OF THE DRAWINGS

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIG. 1 is a explanatory view of a conduction band of a multi-layer structure of the present invention;
FIG. 2 is a graph showing a relation between an energy ratio x and a reflectivity R;
FIG. 3 is an explanatory view of partial quantum-wave interference layers $I_k$;
FIG. 4 is an explanatory view of partial quantum-wave interference layers $I_k$;
FIGS. 5-7 are explanatory view of $\delta$ layers according to the seventh aspect of the present invention;
FIGS. 8A-8C are explanatory views of $\delta$ layers according to the third aspect of the present invention;

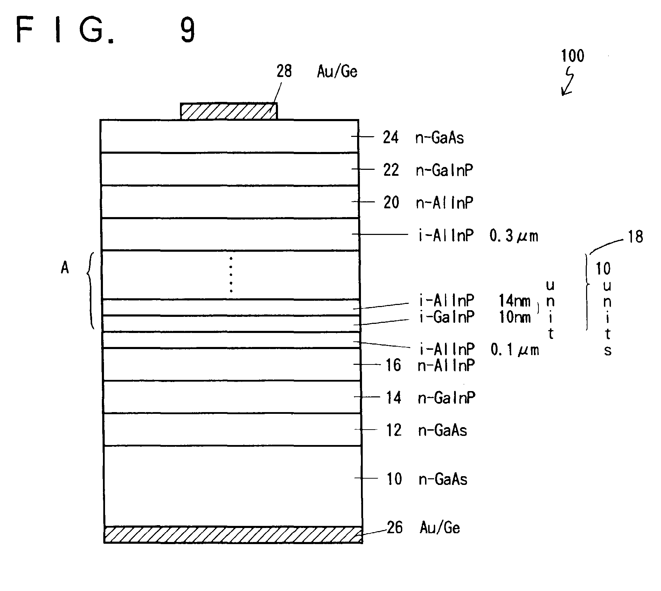

FIG. 9 is a sectional view showing a first exemplary structure of a semiconductor device (Example 1);

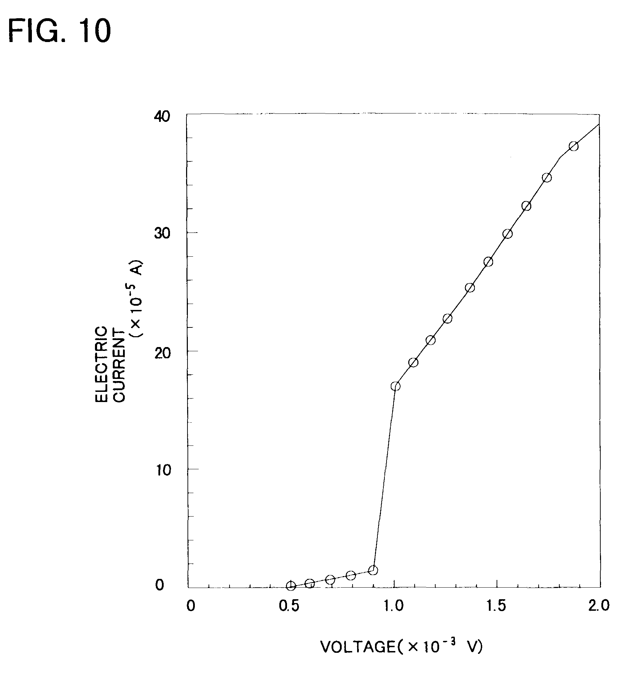

FIGS. 10, 11, and 12 are views showing diagrams of a first exemplary V-I characteristic of a semiconductor device (Example 1); and

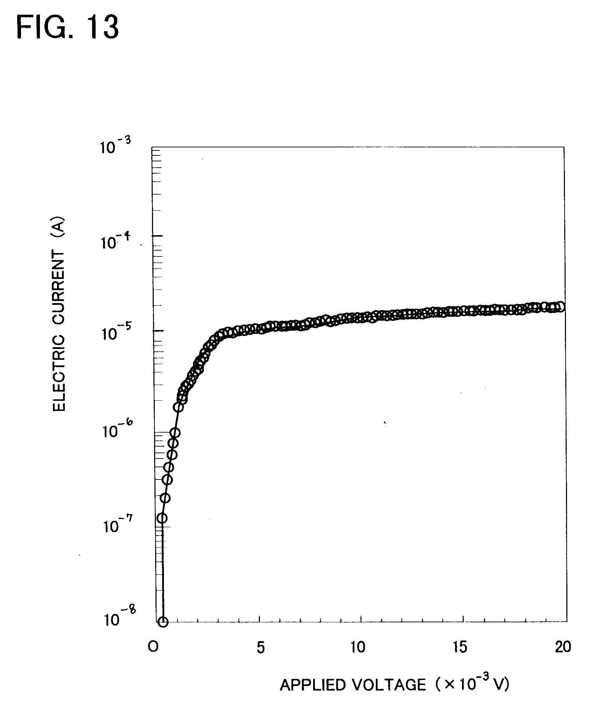

FIG. 13 is a view showing diagrams of a reference exemplary V-I characteristic of a semiconductor device, with thicknesses of the first and second layers determined by multiplying by one fourth of the quantum-wave wavelength.

DETAILED DESCRIPTION OF THE PREFERRED EMBODIMENTS

The invention will be more fully understood by reference to the following examples.

Example 1

FIG. 9 is a sectional view of a semiconductor device 100 having an nin junction structure in which a quantum-wave interference layer is formed in an i-layer. The semiconductor device 100 has a substrate 10 made of gallium arsenide (GaAs). A GaAs buffer layer 12 of n-type conduction, having a thickness generally of 0.3 $\mu$m and an electron concentration of 2 x $10^{18}$/cm$^3$, is formed on the substrate 10. An n-$Ga_{0.51}In_{0.49}P$ contact layer 14 of n-type conduction, having a thickness generally of 0.13 $\mu$m and electron concentration of 2 x $10^{18}$/cm$^3$, is formed on the buffer layer 12. An n-$Al_{0.51}In_{0.49}P$ n-layer 16 of n-type conduction, having a thickness generally of 0.2 $\mu$m and an electron concentration of 1 x $10^{18}$/cm$^3$, is formed on the contact layer 14. A non-doped i-layer 18 is formed on the n-layer 16. A $Al_{0.51}In_{0.49}P$ n-layer 20 of n-type conduction, having a thickness generally of 0.2 $\mu$m and an electron concentration of 1 x $10^{18}$/cm$^3$, is formed on the i-layer 18. A n-$Ga_{0.51}In_{0.49}P$ second contact layer 22 of n-type conduction, having a thickness generally of 0.13 $\mu$m and an electron concentration of 2 x $10^{18}$/cm$^3$, is formed on the n-layer 20. An n-GaAs first contact layer 24 of n-type conduction, having a thickness generally of 0.06 $\mu$m and an electron concentration of 2 x $10^{18}$/cm$^3$, is formed on the second contact layer 22. An electrode layer 26 made of gold and germanium (Au/Ge), having a thickness generally of 0.2 $\mu$m, is formed so as to cover the entire back of the substrate 10. Another electrode layer 28 made of Au/Ge, having a thickness generally of 0.2 $\mu$m, is formed on some portion of the first contact layer 24.

A quantum-wave interference unit A having a multi-quantum layer structure with 10 pairs of a non-doped $Ga_{0.51}In_{0.49}P$ first layer W and a non-doped $Al_{0.51}In_{0.49}P$ second layer B is formed in the i-layer 18. FIG. 8A shows band structures of the quantum-wave interference layer A in detail. The first layer W has a thickness of 10 nm, and the second layer B has a thickness of 14 nm. A non-doped $\delta$ layer made of $Al_{0.33}Ga_{0.33}In_{0.33}P$ is formed at each interface between the first layer W and the second layer B. Thicknesses of the first layer W and the second layer are determined according to Eqs. 1 and 2, respectively, on condition that no external voltage is applied thereto.

The second layers B which contact to the n-layer 20 and the p-layer 16 have thicknesses of 0.3 $\mu$m and 0.1 $\mu$m, respectively. This is because the n-layer 20 prevents a tunneling conduction of electrons from the n-layer 16 to the first layer W. And the substrate 10 has a diameter of 2.0 inches and the normal direction of its main surface is offset toward the [011] axis by 15 degree from the (100) plane.

The semiconductor device 100 was manufactured by gas source molecular beam epitaxial deposition (GS-MBE) which is an epitaxial growth method under extremely high vacuum condition. GS-MBE is different from a conventional MBE which supplies group III and V elements both from solid state sources. In GS-MBE, group III elements such as indium (In), gallium (Ga), and aluminum (Al) are supplied from a solid source and group V elements such as arsenic (As) and phosphorous (P) are supplied by heat decomposition of gas material such as $AsH_3$ and $PH_3$.

V-I characteristic was obtained by applying a voltage to the nin semiconductor device. As shown in FIG. 10, when the applying voltage is about 0.9 mV, the electric current rises sharply with a step function about 20 times as large. It seems that this phenomena is because a wavelength of electrons which flow into a quantum-wave interference layer becomes the double of the thickness of each layer when an external voltage reaches this value. A result of satisfying a high conductive transmission condition seems to bring electric current to flow abruptly. Further, when an external voltage is more increased, a kinetic energy of electrons which flow into the quantum-wave interference layer become larger. And because the wavelength of the quantum-wave becomes smaller than the double of the thickness of each layer, high transmission condition is not satisfied and a flow rate of current decrease. The present inventor thought that the V-I characteristic shown in FIG. 10 was occurred because of such a reason described above.

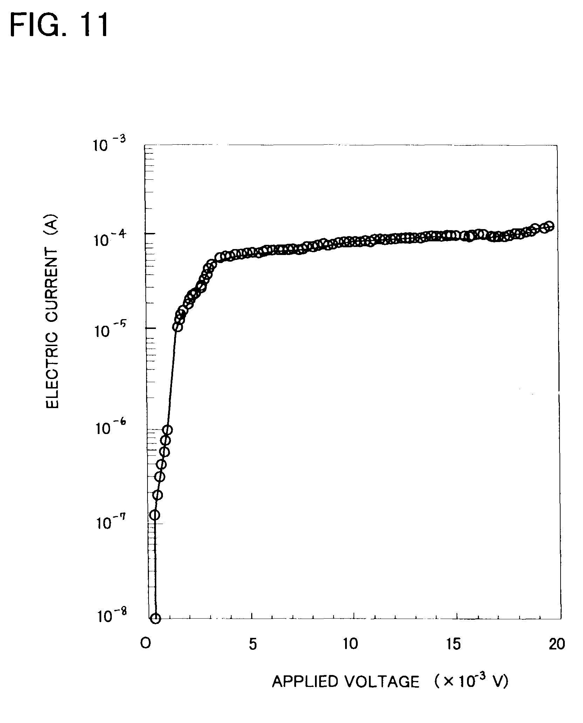

A semiconductor device 200 having 3 pairs of a first layer W and a second layer B is formed. Other condition such as thicknesses or composition ratio of each layer of the semiconductor device 200 is equal to that of the semiconductor device 100 described in Example of 1. V-I characteristics of the semiconductor device 200 is shown in FIG. 11. Similarly, when the applying voltage is about 0.9 mV, the electric current rises abruptly, from $10^{-8}$ to $10^{-5}$, or in the range of 3 orders with a step function.

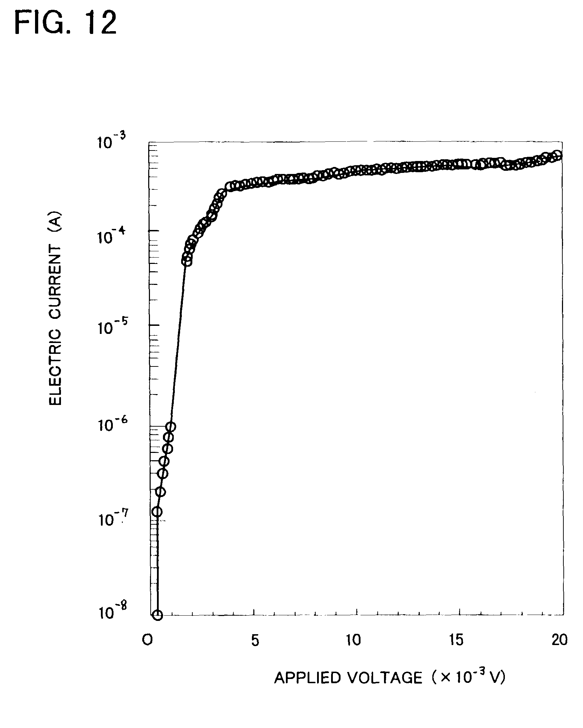

A semiconductor device 300 having 9 pairs of a first layer W and a second layer B is formed. Other condition such as thicknesses or composition ratio of each layer of the semiconductor device 300 is equal to that of the semiconductor device 100 described in Example of 1. V-I characteristics of the semiconductor device 300 is shown in FIG. 12. Similarly, when the applying voltage is about 0.9 mV, the electric current rises abruptly, from $10^{-8}$ to $10^{-5}$, or in the range of 3 orders with a step function , and when the applied voltage is about 3 mV, the electric current rises like a step.

As a reference example, a semiconductor device 400 having 6 pairs of a first layer W and a second layer B. The first layer W and the second layer B have thicknesses of 5 nm and 7 nm, both are half as large as those of the first layer W and the second layer B of the semiconductor device 100. V-I characteristics of the semiconductor device 400 is shown in FIG. 13. Compared with the device shown in the embodiments described above, a gradient of the electric current increment is smaller, and a flowing current amount is also smaller from 1 order to 2 orders. Besides, it has been confirmed by the present inventor that in condition that layers have thicknesses as in the device 400, the quantum-well interference layer functions as a reflection layer. Accordingly, when a forward voltage increases, the electrical current which has been stopped seems to flow abruptly at the voltage that the reflection condition was not satisfied. But it is proved that the current amount is smaller than the current amount when the thickness of each layer is set one half of the quantum wavelength as in the present embodiments. In short, a conductivity on a mobility which is 100 times as large as that of the ordinary device can be obtained by the semiconductor device of the present invention.

A semiconductor device of an nin, or pip type, constituted by a quantum-wave interference layer with plural periods of a pair of a first layer W and a second layer B. The second layer B has wider band gap than the first layer W. Each thicknesses of the first layer W and the second layer B is determined by multiplying by an even number one fourth of wavelength of quantum-wave of carriers in each of the first layer W and the second layer B existing at the level near the lowest energy level of the second layer B. A $\delta$ layer, for sharply varying energy band, is formed at an every interface between the first layer W and the second layer B and has a thickness substantially thinner than the first layer W and the second layer B. Then carriers can have a high conductivity, a high mobility, or a high transmittivity, and a propagation velocity is improved.

## Claims

1.   A semiconductor device comprising:

   a quantum-wave interference layer having plural periods of a pair of a first layer and a second layer, said second layer having a wider band gap than said first layer; characterized in that each thickness of said first and said second layers is determined by multiplying by an even number one fourth of quantum-wave wavelength of carriers in each of said first and said second layers.

2.   A semiconductor device according to claim 1, characterized in that each thickness of said first and said second layers is determined by multiplying by an even number one fourth of quantum-wave wavelength of carriers in each of said first and said second layers existing at a level near the lowest energy level of said second layer.

3.   A semiconductor device according to claim 1 or 2, comprising:

   a $\delta$ layer for sharply varies energy band, being formed between said first and said second layers, characterized in that said $\delta$ layer is substantially thinner than that of said first and said second layers.

4.   A semiconductor device according to claims 1 to 3, characterized in that said wavelength $\lambda_W$ in said first layer is determined by a formula $\lambda_W = h/[2m_W(E+V)]^{1/2}$ , said wavelength $\lambda_B$ in said second layer is determined by a formula $\lambda_B = h/(2m_B E)^{1/2}$ , said thickness of said first layer $D_W$ is determined by a formula $D_W = n_W \lambda_W/4$ , and said thickness of said second layer $D_B$ is determined by a formula $D_B = n_B \lambda_B /4$, where h, $m_W$, $m_B$, E, V, and $n_W$ and $n_B$ represent a plank constant, effective mass of said carrier in said first layer, effective mass of said carrier in said second layer, kinetic energy of carriers at the level near the lowest energy level in said second layer, potential energy of said second layer to said first layer, and even numbers, respectively.

5.   A semiconductor device according to claims 1 to 4, comprising:

   a plurality of partial quantum-wave interference layer $I_k$ with $T_k$ periods of a pair of said first layer and said second layer being displaced in series by varying k as 1, 2, ..., and characterized in that index k of said plurality of said partial quantum-wave interference layers correspond to index k of kinetic energy level $E_k$ and said first and second layers have thicknesses of $n_{Wk}\lambda_{Wk}/4$, and $n_{Bk}\lambda_{Bk}/4$, respectively, where $E_k+V$ and $E_k$, $\lambda_{Wk}$ and $\lambda_{Bk}$ , and $n_{Wk}$, $n_{Bk}$ represent kinetic energy level of carriers flowing into respective said first layer and said second layer, wavelength of quantum-wave of carriers flowing into respective said first layer and said second layer, and even numbers, respectively, and $\lambda_{Wk}$ and $\lambda_{Bk}$ are determined by functions of $E_k+V$ and $E_k$, respectively.

6.   A semiconductor device according to claims 1 to 4, comprising:

   a plurality of partial quantum-wave interference layer, each of said partial quantum-wave interference layer having serial pairs of said first layer and said second layer with serial pairs of thicknesses of ($n_{W1}\lambda_{W1}/4$, $n_{B1}\lambda_{B1}/4$), ..., ($n_{Wk}\lambda_{Wk}/4$, $n_{Bk}\lambda_{Bk}/4$), ..., ($n_{Wj}\lambda_{Wj}/4$, $n_{Bj}\lambda_{Bj}/4$) where $E_k+V$ and $E_k$, $\lambda_{Wk}$ and $\lambda_{Bk}$, and $n_{Wk}$, $n_{Bk}$ represent kinetic energy level of carriers flowing into respective said first layer and said second layer, wavelength of quantum-wave of carriers flowing into respective said first layer and said second layer, and even numbers, respectively, and $\lambda_{Wk}$ and $\lambda_{Bk}$ are determined by functions of $E_k+V$ and $E_k$, respectively.

7.   A semiconductor device having a plurality of semiconductor layers comprising of hetero-material with different band width, further comprising:

   a quantum-wave interference layer including a plurality of $\delta$ layers for sharply varying energy band, said $\delta$ lay-

ers being formed at the interval of one fourth of wavelength of quantum-wave of carriers multiplied by an even number, and thickness of said δ layers being substantially thinner than width of said interval.

8. A semiconductor device according to claims 1 to 7, characterized in that said quantum-wave interference layer functions as a transmission layer for transmitting said carriers.

9. A semiconductor device according to claims 1 to 8, characterized in that an incident plane of quantum-wave in said quantum-wave interference layer is said second layer having enough thickness to prevent conduction of carriers by a tunneling effect.

10. A semiconductor device according to claims 1 to 9, further comprising an nin or a pip structure, and characterized in that said quantum-wave interference layer is formed in an i-layer.

11. A semiconductor device according to claim 10, charactrized in that a band width of said second layer formed in said i-layer is corresponded to that of an n-layer or a p-layer.

12. A semiconductor device of said nin structure according to claim 10, characterized in that the lowest level of a conduction band of said second layer formed in said i-layer is corresponded to the lowest level of a conduction band in an n-layer.

13. A semiconductor device of said pip structure according to claim 10, charactrized in that the lowest level of a valence band of said second layer formed in said i-layer is corresponded to the lowest level of a valence band in a p-layer.

# F I G. 1

E

V

E+V

e

B₀          B    W

# F I G. 2

Reflectivity R

1.0

0.5

0

0.5          1.0

Energy Ratio  X

EP 0 967 658 A2

# F I G. 3

F I G. 4

$E_j$

$E_2$

$E_1$

$I_1$ $I_2$

$B_0$ W B W B ··· ··· $D_{W1}$ $D_{B1}$ $D_{W2}$ $D_{B2}$ $D_{WJ}$ $D_{BJ}$

F I G. 5

$\delta$ $\delta$ $\delta$

$D_B$ $D_B$

$B_0$ B

F I G. 6

B

$B_0$ $D_B$ $D_B$

$\delta$ $\delta$ $\delta$

F I G. 7

$\delta$ $\delta$

$D_B$ $D_B$

$B_0$ B

$\delta$

# F I G. 8 A

# F I G. 8 B

# F I G. 8 C

# F I G. 9

28 Au/Ge

100

A

— 24 n-GaAs

— 22 n-GaInP

— 20 n-AlInP

— i-AlInP 0.3 μm — 18

— i-AlInP 14nm unit } 10 units

— i-GaInP 10nm

— i-AlInP 0.1 μm

— 16 n-AlInP

— 14 n-GaInP

— 12 n-GaAs

— 10 n-GaAs

— 26 Au/Ge

# FIG. 10

# FIG. 11

## FIG. 12

# FIG. 13

ELECTRIC CURRENT (A) vs APPLIED VOLTAGE ($\times 10^{-3}$ V)